# EUROPÄISCHE PATENTSCHRIFT

(11) **EP 3 453 231 B1**
(45) Veröffentlichungstag und Bekanntmachung des Hinweises auf die Patenterteilung: **24.07.2019**
(21) Anmeldenummer: 17723243.6
(22) Anmeldetag: 05.05.2017
(51) Int. Cl.: H05B 33/08

(54) **KRAFTFAHRZEUG-BELEUCHTUNGSEINRICHTUNG**
MOTOR VEHICLE ILLUMINATION DEVICE
MOYEN D'ÉCLAIRAGE DE VÉHICULE AUTOMOBILE

(30) Priorität: 06.05.2016 AT 504172016
(43) Veröffentlichungstag der Anmeldung: 13.03.2019
(73) Patentinhaber: ZKW Group GmbH, 3250 Wieselburg (AT)
(72) Erfinder: GUTH, Christian, 7433 Mariasdorf (AT)
(74) Vertreter: Patentanwaltskanzlei Matschnig & Forsthuber OG
(86) Internationale Anmeldenummer: PCT/AT2017/060119
(87) Internationale Veröffentlichungsnummer: WO 2017/190172

(56) Entgegenhaltungen:
- EP-A1- 2 670 218
- WO-A1-2014/095173
- US-A1- 2006 038 803
- US-A1- 2015 230 302

## Beschreibung

Die Erfindung bezieht sich auf eine Kraftfahrzeug-Beleuchtungseinrichtung mit zumindest einem Zweig von Halbleiter-Lichtquellen, der zwei oder mehr in Serie geschaltete Lichtquelleneinheiten umfasst, wobei einzelnen Lichtquelleneinheiten ein diese überbrückender MOSFET-Schalter zugeordnet ist, der zumindest eine Zweig von der Ausgangsspannung eines DC/DC-Wandlers gegen Masse gespeist ist, wobei jedem MOSFET-Schalter zu dessen Ansteuerung eine Ansteuerschaltung zugeordnet ist.

Bei Kraftfahrzeug-Beleuchtungseinrichtungen dieser Art, beispielsweise bei Scheinwerfern, ist eine Anzahl von Lichtquelleneinheiten vorgesehen, die zur Verwirklichung komplexe Lichtfunktionen, wie Matrix- oder Kurvenlicht- Funktionen einzeln ein- oder ausgeschaltet werden oder auch periodisch im Sinne eines Dimmens getaktet werden. Als Lichtquellen werden meist LEDs oder Laserdioden, letztere oft mit Lichtkonversionsmitteln, verwendet. Der hier verwendete Begriff "Lichtquelleneinheiten" soll beinhalten, dass auch die Serienschaltung von Kombinationen einzelner in Serie und/oder parallel geschalteter Einzellichtquellen, z.B. LEDs, umfasst sein sollen, wobei eine solche Kombination eine Lichtquelleneinheit bildet.

Grundsätzlich basieren alle gängigen Schaltungskonzepte darauf, dass die zu aktivierende/deaktivierende Lichtquelleneinheiten, z.B. eine LED, mittels eines Halbleiter-Schalters überbrückt wird, sodass der Strom über den Schalter anstatt über die LED fließt. Als Halbleiter-Schalter dienen in der Regel MOS-FETs, Bipolar- Transistoren oder auch voll integrierte IC-Lösungen.

Bei gegenständlichen Kraftfahrzeug-Beleuchtungseinrichtungen besteht zusätzlich die Problematik, dass in der Regel, bei wechselnder LED Anzahl und der einhergehenden variierenden LED Strang Spannung, nur DC/DC-Wandler zum Einsatz kommen können, die auf Spannungen größer und kleiner der Eingangsspannung regeln können, beispielsweise Cuk-Wandler oder SEPIC-Wandler.

Ein dabei auftretendes Problem liegt darin, die für die Schalter erforderlichen Spannungswerte bereitzustellen und an die dynamisch wechselnden Schaltschwellen der einzelnen Schalter anzupassen, um die Funktionalität in vollem Umfang aller möglichen LED-Kombinationen nutzen zu können. Gängige Lösungen verursachen mitunter hohe Verlustleistungen bei der Umsetzung bzw. sie sind vom Funktionsumfang her eingeschränkt oder für spezielle Anwendungen hinsichtlich der Kosten und der Anzahl der Bauteile Anzahl zu kompliziert. Beispielsweise ist die Ansteuerung oft verwendeter n-Kanal-MOSFETs mit relativ hoher Verlustleistung verbunden und oft ist dazu eine Ladungspumpe erforderlich. Prinzipiell mögliche Lösungen mit Transformatoren oder Optokopplern sind teuer und im Automotive-Bereich schwierig zu implementieren, was auch für vollintegrierte Lösungen gilt.

Aus der WO 2014/095173 A1 geht eine Ansteuerschaltung für einen Feldeffekttransistor hervor, der parallel zu einer LED geschaltet ist. Um eine rasch arbeitende, gegen Störungen und Spannungsschwankungen unempfindliche Ansteuerung zu ermöglichen, sind ein von einer eigenen Spannungsquelle gespeister Stromspiegel sowie ein Pegelwandler für Ansteuersignale vorgesehen. Die der Erfindung zu Grunde liegende Problematik bei Einsatz von zwei oder mehr in Serie geschalteten LEDs wird in diesem Dokument nicht beschrieben oder gelöst.

Das Dokument US 2006/038803 A1 betrifft eine Ansteuerschaltung für einen mehrere LEDs aufweisenden Zweig, wobei jeder LED ein FET-Schalter parallel geschaltet ist. Der Strom durch den LED-Zweig wird durch eine Regelung konstant gehalten, doch kann jede LED bzw. der ihr zugeordnete FET-Schalter getrennt von einem Mikrocontroller angesteuert werden. Eine Lösung zum Bereitstellen einer Gleichspannung für die Ansteuerschaltung der LEDs aus einem DC/DC-Wandler ist diesem Dokument nicht zu entnehmen.

Das Dokument US 2015/230302 A1 offenbart eine Kraftfahrzeug-Beleuchtungseinrichtung gemäß dem Oberbegriff des Anspruchs 1.

Eine Aufgabe der Erfindung liegt darin, eine voll funktionssichere jedoch kostengünstige Lösung der genannten Probleme für eine Kraftfahrzeug-Beleuchtungseinrichtung der hier in Frage stehenden Art zu erhalten.

Diese Aufgabe wird mit einer Kraftfahrzeug-Beleuchtungseinrichtung der eingangs genannten Art gelöst, bei welcher erfindungsgemäß jeder MOSFET-Schalter ein p-Kanal-MOSFET ist, dem DC/DC-Wandler eine Gleichrichterschaltung zugeordnet ist, deren Eingang mit einem Pol einer Speicherinduktivität des Wandlers verbunden ist, an welchem gegen Masse negative Spannungsimpulse auftreten, und die Gleichrichterschaltung dazu ausgebildet ist, die negativen Impulse gleichzurichten und die sich ergebende negative Gleichspannung der Ansteuerschaltung zum Schalten des jeweiligen MOSFETs zur Verfügung zu stellen.

Die Erfindung führt zu einer kostengünstigen Lösung, die auch das gleichzeitige Überbrücken mehrerer LEDs ermöglicht, was beispielsweise bei integrierten Konzepten nicht möglich ist. Weiters können auch jene MOSFETs problemlos angesteuert werden, deren Source auf Massepotential liegt.

Bei zweckmäßigen Varianten ist vorgesehen, dass der DC/DC-Wandler ein Cuk-Wandler oder ein SEPIC-Wandler ist.

Eine kostengünstige Lösung sieht vor, dass die Gleichrichterschaltung eine Gleichrichterdiode zur Erzeugung der Gleichspannung enthält.

Weiters ist es vorteilhaft, wenn die Gleichrichterschaltung zusätzlich Siebmittel für die Gleichspannung aufweist.

Auch ist es sehr empfehlenswert, wenn die Gleichrichterschaltung Stabilisierungsmittel für die Gleichspannung aufweist.

Bei einer praxisgerechten Ausführung ist vorgesehen, dass jede Ansteuerschaltung einen in Kollektorschaltung betriebenen npn-Transistor aufweist, dessen Kollektor mit dem Gate des zugehörigen MOSFET-Schalters verbunden ist.

In diesem Fall empfiehlt es sich weiters, dass dem npn-Transistor ein pnp-Vorstufentransistor vorgeschaltet ist.

Zweckmäßig als Ausgangspunkt für die gesamte Ansteuerung ist es, wenn ein Mikrocontroller vorgesehen ist, dessen Ausgänge zu Ansteuerschaltungen für die MOSFET-Schalter geführt sind.

Die Erfindung samt weiteren Vorteilen ist im Folgenden an Hand beispielsweiser Ausführungsformen näher erläutert, die in der Zeichnung veranschaulicht sind. In dieser zeigen
Fig. 1 in einem vereinfachten Blockschaltbild den prinzipiellen Aufbau der Erfindung und
Fig. 2 mehr detailliert weitere Einzelheiten einer Ausführungsform der Erfindung.

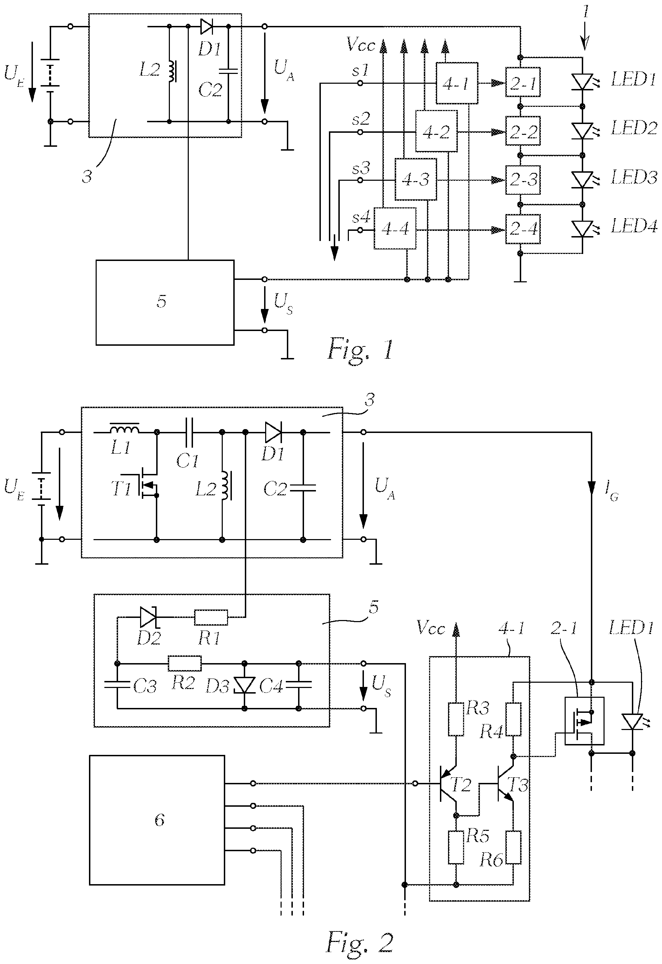

Das Blockschaltbild nach Fig. 1 zeigt in schematischer und vereinfachter Form die wesentlichen Elemente der Ansteuerung einer erfindungsgemäßen Kraftfahrzeug-Beleuchtungseinrichtung. Gezeigt ist ein Zweig 1 mit in diesem Beispiel vier in Serie geschalteten Halbleiter-Lichtquelleneinheiten LED1 ...LED 4, wobei jeder Lichtquelleneinheit ein diese überbrückender MOSFET-Schalter 2-1....2-4 zugeordnet ist. Der Zweig 1 ist von der Ausgangsspannung UA eines DC/DC-Wandlers 3 gegen Masse gespeist ist, wobei jedem MOSFET-Schalter 2-1....2-4 zu dessen Ansteuerung eine Ansteuerschaltung 4-1....4-4 zugeordnet ist. Die Eingangsspannung UE des DC/DC-Wandlers 3 wird im Allgemeinen dem Bordnetz eines Kraftfahrzeuges entnommen sein. Die Ansteuerschaltungen 4-1....4-4 erhalten eine Versorgungsspannung VCC von beispielsweise +5V. Wie weiter unten näher gezeigt und beschrieben sind den Ansteuerschaltungen 4-1....4-4 Schaltsignale sl....s4 zugeführt.

Als Halbleiter-Lichtquelleneinheiten werden, dies wurde bereits eingangs erwähnt, bevorzugt LEDs oder Laserdioden, diese oft zusammen mit Lichtkonversionsmitteln, verwendet. Der hier verwendete Begriff "Lichtquelleneinheit" soll beinhalten, dass prinzipiell jede der Lichtquelleneinheiten LED1 ... LED 4 auch eine Kombination einzelner in Serie und/oder parallel geschalteter Einzellichtquellen, z.B. LEDs, umfassen kann. Wenngleich in dem Zweig 1 hier vier Lichtquelleneinheiten LED1 ...LED 4 gezeigt sind, kann diese Anzahl unterschiedlich sein und die Beleuchtungseinrichtung kann auch mehrere solcher Zweige umfassen.

Jeder MOSFET-Schalter 2-1....2-4 ist gemäß der Erfindung ein p-Kanal-MOSFET und dem DC/DC-Wandler 3 ist eine Gleichrichterschaltung 5 zugeordnet, deren Eingang mit einem Pol einer Speicherinduktivität L2 des noch näher zu beschreibenden Wandlers verbunden ist, an welchem gegen Masse negative Spannungsimpulse auftreten. Die Gleichrichterschaltung 5 ist dazu ausgebildet, die negativen Impulse gleichzurichten und die sich ergebende negative Gleichspannung US der Ansteuerschaltung als Schaltspannung zum Schalten des jeweiligen MOSFETs 2-1....2-4 zur Verfügung zu stellen. Jeder MOSFET-Schalter 2-1....2-4 soll den Strom über die jeweilige Lichtquelleneinheiten LED1 ...LED 4 überbrücken und diese somit ausschalten beziehungsweise pulsweitenmoduliert in ihrer Helligkeit dimmen können.

Der DC/DC-Wandler 3 kann in vorteilhafter Weise die Ausgangsspannung UA sowohl höher als auch tiefer setzen als die Eingangsspannung UE, wobei die Ausgangsspannung UA so geregelt wird, sodass die Lichtquelleneinheiten LED1 ...LED 4 im notwendigen Arbeitspunkt des gewünschten Versorgungsstromes IG betrieben werden. Beispielsweise kommen SEPIC-Wandler oder Cuk -Wandler den Fachkreisen bekannte Wandler in Frage, bei welchen aufgrund der Topologie eine negative Spannung an einer Speicherdrossel entsteht, welche für die Realisierung der Erfindung wesentlich ist. Ein Cuk-Wandler kann auch mit einem Übertrager isolierend aufgebaut werden.

Fig. 2 zeigt eine detaillierte Ausführung der erfindungsgemäßen Ansteuerung. Der DC/DC-Wandler 3 ist hier als SEPIC-Wandler ausgebildet, der in bekannter Weise über drei Energiespeicher verfügt - zwei Induktivitäten L1, L2 und einen Kondensator C1. Die Induktivitäten können auf einem gemeinsamen Spulenkörper angeordnet sein. Der auf die Eingangsspannung UE aufgeladene Kondensator C1 lädt seine Energie in der Phase, in welcher der Halbleiterschalter T1 ausgeschaltet ist, auf die Induktivität L2 um. Zwischen der Diode D1, die in dieser Phase in Sperrrichtung arbeitet, und dem Kondensator C1 bzw. der Induktivität L2 entsteht dabei eine negative Spannung die der Gleichrichterschaltung 5 zugeführt wird.

Die Gleichrichterschaltung 5 weist eingangsseitig ein Dioden-Kondensator-Netzwerk D2, C3 auf um die negative Spannung abzugreifen und gleichzurichten. Die Diode D2 verhindert, dass sich ein folgender Kondensator C3 im Durchlassbetrieb der Diode D1 auf eine positive Spannung aufladen kann und wirkt daher als Gleichrichterdiode. Ausgangsseitig dient eine Zenerdiode D3 zur Spannungsstabilisierung, wobei jene Spannung abgeleitet wird, die über der Durchbruchsspannung dieser Zenerdiode D3 liegt. Die Widerstände R1 und R2 dienen zur Strombegrenzung. Ein Kondensator C4 am Ausgang der Gleichrichterschaltung 5 erhöht den Stabilisierungseffekt und verringert Restwelligkeiten. Die damit von der Durchbruchsspannung der Zenerdiode D3 abhängige Ausgangspannung US kann als Schaltspannung zum Schalten der MOSFET-Schalter 2-1....2-4 für die Ansteuerschaltungen 4-1....4-4 bereitgestellt werden.

Jede dieser Ansteuerschaltungen 4-1....4-4 besteht, wie hier für die Ansteuerschaltung 4-1 gezeigt ist, beispielsweise aus einem npn-Transistor T3 in Kollektorschaltung mit einem vorgeschalteten Transistor T2, der als Vorstufentransistor von einem Mikrocontroller 6 gesteuert wird, um die Basis des Transistors T3 zwischen einer positiven und der von der Gleichrichterschaltung 5 bereitgestellten negativen Spannung US zu schalten. Der Kollektor des Transistors T3 ist der Ausgang der Ansteuerschaltung 4-1 und liegt somit am Gate des zugehörigen MOSFET-Schalters 2-1.

Im vorliegenden Fall sei die positive Spannung die resultierende Spannung aus der Versorgungsspannung VCC, z.B. +5V, abzüglich der Spannungsabfälle an R3 und T2 und die negative Spannung US sei -5V. Schaltet der Mikrocontroller 6 auf logisch "High" (5V) so sperrt der Transistor T2 und die Basisspannung des Transistors T3 liegt über den Widerstand R5 an -5V. Der MOSFET-Schalter 2-1 wird nicht aktiviert, da es zu keinem Stromfluss und somit zu keinem Spannungsabfall an dem Widerstand R4 kommt. Schaltet der Mikrocontroller die Basisspannung des Transistors T2 hingegen auf logisch "Low" (0V), so fließt im Zweig mit dem Widerstand R6 ein konstanter Strom und dementsprechend fällt eine konstante Spannung an dem Widerstand R4 ab, die am Kollektor des Transistors T3 und damit am Gate-Eingang des p-Kanal-MOSFET-Schalters 2-1 ein niedrigeres Potential aufweist als an dessen Source-Elektrode. In diesem Fall schließt der MOSFET-Schalter 2-1 und überbrückt die Lichtquelleneinheit LED1.

Im vorliegenden Fall erfolgt die Stabilisierung der Spannung US in der Gleichrichterschaltung 5 mittels der Zenerdiode D3, doch sollte es klar sein, dass dies nicht die Erfindung einschränkend zu sehen ist. Vielmehr kann eine Spannungsstabilisierung beispielsweise auch mittels eines Linearreglers, z.B. unter Verwendung eines Operationsverstärkers, erfolgen.

Wie bereits angedeutet ist auch eine Anordnung der Halbleiterlichtquelleneinheiten LED1-LED4 nicht zwingend in einem einzigen Zweig erforderlich. Die Halbleiterlichtquelleneinheiten könnten beispielsweise auch auf zwei Zweige aufgeteilt sein. Auch kann ein Ausgang des Mikrocontrollers 6 zwei oder mehr der Ansteuerschaltungen 4-1... 4-4 gleichzeitig ansteuern. Die Anzahl der Halbleiterlichtquelleneinheiten ist selbstverständlich beliebig wählbar und nicht auf vier, wie im Beispiel dargestellt, beschränkt.

Wesentlich für die Erfindung ist das Abgreifen einer negativen Spannung an dem DC/DC-Wandler 3 um daraus eine stabile negative Spannung zu gewinnen, welche für die Ansteuerung der MOSFET-Schalter 2-1....2-4 verwendbar ist. Die gezeigten Elemente zur Bereitstellung sowie zur Stabilisierung der negativen Spannung stellen nur eine beispielhafte Ausführung dar, die im vorliegenden gezeigten Beispiel jedenfalls eine kostengünstige und zugleich effiziente Lösung ist und somit in Verbindung mit der beschriebenen Erfindung besondere Vorteile aufweist.

Auch liegt die Wahl der ergänzenden Schaltelemente in der Hand des ausführenden Fachmanns, wobei beispielsweise weiterführende Filterelemente und Schutzelemente möglich, jedoch der Übersichtlichkeit halber nicht gezeigt sind.

## Patentansprüche

1. Kraftfahrzeug-Beleuchtungseinrichtung mit einem DC/DC Wandler (3) und mit zumindest einem Zweig (1) von Halbleiter-Lichtquellen, der zwei oder mehr in Serie geschaltete Lichtquelleneinheiten (LED1 ... LED4) umfasst, wobei einzelnen Lichtquelleneinheiten ein diese überbrückender MOSFET-Schalter (2-1 ... 2-4) zugeordnet ist, der zumindest eine Zweig von der Ausgangsspannung (U_{A}) des DC/DC-Wandlers (3) gegen Masse gespeist ist,
**dadurch gekennzeichnet, dass**
jedem MOSFET-Schalter zu dessen Ansteuerung eine Ansteuerschaltung (4-1 ... 4-4) zugeordnet ist,
jeder MOSFET-Schalter (2-1 ... 2-4) ein p-Kanal-MOSFET ist,
dem DC/DC-Wandler (3) eine Gleichrichterschaltung (5) zugeordnet ist, deren Eingang mit einem Pol einer Speicherinduktivität (L2) des Wandlers verbunden ist, an welchem gegen Masse negative Spannungsimpulse auftreten, und
die Gleichrichterschaltung (5) dazu ausgebildet ist, die negativen Impulse gleichzurichten und die sich ergebende negative Gleichspannung (U_{S}) der Ansteuerschaltung (4-1 ... 4-4) zum Schalten des jeweiligen MOSFET-Schalters zur Verfügung zu stellen.

2. Kraftfahrzeug-Beleuchtungseinrichtung nach Anspruch 1, **dadurch gekennzeichnet, dass** der DC/DC-Wandler (3) ein Ćuk-Wandler ist.

3. Kraftfahrzeug-Beleuchtungseinrichtung nach Anspruch 1, **dadurch gekennzeichnet, dass** der DC/DC-Wandler (3) ein SEPIC-Wandler ist

4. Kraftfahrzeug-Beleuchtungseinrichtung nach einem Ansprüche 1 bis 3, **dadurch gekennzeichnet, dass** die Gleichrichterschaltung (5) eine Gleichrichterdiode (D2) zur Erzeugung der Gleichspannung (U_{S}) enthält.

5. Kraftfahrzeug-Beleuchtungseinrichtung nach einem Ansprüche 1 bis 4, **dadurch gekennzeichnet, dass** die Gleichrichterschaltung (5) zusätzlich Siebmittel (C3, C4) für die Gleichspannung (U_{S}) aufweist.

6. Kraftfahrzeug-Beleuchtungseinrichtung nach einem Ansprüche 1 bis 5, **dadurch gekennzeichnet, dass** die Gleichrichterschaltung (5) Stabilisierungsmittel (D3) für die Gleichspannung (U_{S}) aufweist.

7. Kraftfahrzeug-Beleuchtungseinrichtung nach einem Ansprüche 1 bis 6, **dadurch gekennzeichnet, dass** jede Ansteuerschaltung (4-1...4-4) einen in Kollektorschaltung betriebenen npn-Transistor (T3) aufweist, dessen Kollektor mit dem Gate des zugehörigen MOSFET-Schalters (2-1) verbunden ist.

8. Kraftfahrzeug-Beleuchtungseinrichtung nach Anspruch 7, **dadurch gekennzeichnet, dass** dem npn-Transistor (T3) ein pnp-Vorstufentransistor (T2) vorgeschaltet ist.

9. Kraftfahrzeug-Beleuchtungseinrichtung nach einem Ansprüche 1 bis 8, ferner umfassend einen Mikrocontroller (6) mit Ausgängen zum Steuern der Ansteuerschaltungen (4-1...4-4) für die MOSFET-Schalter (2-1 ... 2-4).

## Claims

1. A motor vehicle lighting device, comprising a DC/DC converter (3) and at least one branch (1) of semiconductor light sources which includes two or more light source units (LED1 to LED4) connected in series, a MOSFET switch (2-1 to 2-4) bridging the individual light source units being assigned to these, the at least one branch being fed from the output voltage (U_{A}) of the DC/DC converter (3) with respect to ground, **characterized in that** each MOSFET switch is assigned an activation circuit (4-1 to 4-4) for activating the same,
each MOSFET switch (2-1 to 2-4) is a p-channel MOSFET,
a rectifier circuit (5) is assigned to the DC/DC converter (3), the input of the rectifier circuit being connected to a pole of a storage inductor (L2) of the converter, at which negative voltage pulses occur with respect to ground, and
the rectifier circuit (5) is designed to rectify the negative pulses and to provide the resulting negative DC voltage (U_{S}) of the activation circuit (4-1 to 4-4) for switching the respective MOSFET switch.

2. The motor vehicle lighting device according to claim 1, **characterized in that** the DC/DC converter (3) is a Ćuk converter.

3. The motor vehicle lighting device according to claim 1, **characterized in that** the DC/DC converter (3) is a SEPIC converter.

4. The motor vehicle lighting device according to any one of claims 1 to 3, **characterized in that** the rectifier circuit (5) comprises a rectifier diode (D2) for generating the DC voltage (U_{S}).

5. The motor vehicle lighting device according to any one of claims 1 to 4, **characterized in that** the rectifier circuit (5) additionally comprises filter means (C3, C4) for the DC voltage (U_{S}).

6. The motor vehicle lighting device according to any one of claims 1 to 5, **characterized in that** the rectifier circuit (5) comprises stabilizing means (D3) for the DC voltage (U_{S}).

7. The motor vehicle lighting device according to any one of claims 1 to 6, **characterized in that** each activation circuit (4-1 to 4-4) comprises an npn transistor (T3) operated in a common collector configuration, the collector of the transistor being connected to the gate of the associated MOSFET switch (2-1).

8. The motor vehicle lighting device according to claim 7, **characterized in that** a small signal pnp transistor (T2) is connected upstream of the npn transistor (T3).

9. The motor vehicle lighting device according to any one of claims 1 to 8, further comprising a microcontroller (6) having outputs for controlling the activation circuits (4-1 to 4-4) for the MOSFET switches (2-1 to 2-4).

## Revendications

1. Dispositif d'éclairage pour véhicule automobile comportant un convertisseur continu/continu (3) et comportant au moins une branche (1) de sources de lumière à semi-conducteur, qui comporte au moins deux unités de source de lumière montées en série (LED1... LED4), un commutateur MOSFET (2-1... 2-4) pontant celles-ci étant affecté à chaque unité de source de lumière, ladite au moins une branche étant alimentée par la tension de sortie (U_{A}) du convertisseur continu/continu (3) par rapport à la masse,
**caractérisé par le fait que**
un circuit de commande (4-1... 4-4) est affecté à chaque commutateur MOSFET pour sa commande,
chaque commutateur MOSFET (2-4... 2-4) est un MOSFET à canal p,
au convertisseur continu/continu (3) est affecté un circuit redresseur (5) dont l'entrée est reliée à un pôle d'une inductance de stockage (M2) du convertisseur, entrée au niveau de laquelle apparaissent des impulsions de tension négatives par rapport à la masse, et
le circuit redresseur (5) est adapté pour redresser les impulsions négatives et pour délivrer la tension continue négative résultante (U_{S}) du circuit de commande (4-1... 4-4) afin de commuter le commutateur MOSFET respectif.

2. Dispositif d'éclairage pour véhicule automobile selon la revendication 1, **caractérisé par le fait que** le convertisseur continu/continu (3) est un convertisseur Ćuk.

3. Dispositif d'éclairage pour véhicule automobile selon la revendication 1, **caractérisé par le fait que** le convertisseur continu/continu (3) est un convertisseur SEPIC.

4. Dispositif d'éclairage pour véhicule automobile selon l'une des revendications 1 à 3, **caractérisé par le fait que** le circuit redresseur (5) contient une diode redresseuse (D2) pour la génération de la tension continue (U_{S}).

5. Dispositif d'éclairage pour véhicule automobile selon l'une des revendications 1 à 4, **caractérisé par le fait que** le circuit redresseur (5) présente en outre des moyens de filtre (C3, C4) pour la tension continue (U_{S}).

6. Dispositif d'éclairage pour véhicule automobile selon l'une des revendications 1 à 5, **caractérisé par le fait que** le circuit redresseur (5) présente des moyens de stabilisation (D3) pour la tension continue (U_{S}).

7. Dispositif d'éclairage pour véhicule automobile selon l'une des revendications 1 à 6, **caractérisé par le fait que** chaque circuit de commande (4-1... 4-4) présente un transistor npn (T3) actionné dans une configuration à collecteur commun, dont le collecteur est relié à la grille du commutateur MOSFET associé (2-1).

8. Dispositif d'éclairage pour véhicule automobile selon la revendication 7, **caractérisé par le fait qu'**un transistor pnp à petits signaux (12) est monté en amont du transistor npn (T3).

9. Dispositif d'éclairage pour véhicule automobile selon l'une des revendications 1 à 8, comportant en outre un microcontrôleur (6) ayant des sorties pour la commande des circuits de commande (4-1... 4-4) pour les commutateurs MOSFET (2-1... 2-4) .
